# EUROPEAN PATENT SPECIFICATION

(11) **EP 0 656 856 B1**
(45) Date of publication and mention of the grant of the patent: **27.01.1999**
(21) Application number: 94920011.7
(22) Date of filing: 17.05.1994
(51) Int. Cl.: B65D 43/16, E05D 3/06, A45C 13/00, G06F 1/16, H05K 5/02

(54) **FRICTION CLUTCH FOR DUAL PIVOT POINT HINGE**
REIBUNGSKUPPLUNG FÜR EIN DOPPELSCHARNIERGELENK
ACCOUPLEMENT A GLISSEMENT POUR CHARNIERE A DOUBLE PIVOT

(30) Priority: 21.06.1993 US 79301
(43) Date of publication of application: 14.06.1995
(73) Proprietor: MOTOROLA, INC., Schaumburg, IL 60196 (US)
(72) Inventor: ADY, Roger, W., Lisle, IL 60532 (US); GROVES, William, R., Naperville, IL 60565 (US)
(74) Representative: Gibson, Sarah Jane
(86) International application number: US9405440
(87) International publication number: WO9500406

(56) References cited:
- WO-A-93/01700
- US-A- 2 546 590
- US-A- 3 613 152
- US-A- 4 684 017
- US-A- 4 840 288
- US-A- 4 892 189
- US-A- 4 976 007
- US-A- 5 016 849

## Description

### Technical Field

The present invention generally relates to hinges, and particularly, to dual pivot point hinges. Specifically, the present invention relates to a clutch mechanism for use with a dual pivot point hinge adapted for use with electronic housing assemblies and the like.

### Background of the Invention

Electronic housing assemblies for enclosing portable computing and/or communicating devices such as portable computers, palm-top computers, electronic notebooks, portable personal organizers, portable intelligent communicators (PICs) and the like are known. Typically, such enclosures employ a lid or cover which is pivotally connected by a hinge or an equivalent mechanical mechanism to a device base or body. A display screen, integral to the cover, may be employed such that when the cover is closed, the display screen is protected from damage.

In most instances, the cover can only pivot to a limited extent (i.e., 90° to about 180°). As a result, known palm-top and lap-top computers and communicators typically provide a very limited number of screen or display orientations and generally offer the user only one or two ways of orienting the display screen.

WO-A-9301700 describes a lap-top computer with a hinged display. The hinge can consist of a pivot plate comprising a pair of pivot pins at each end. One of each pair of pivot pins may be engaged by an 'inboard' shaft, which itself rotates inside an 'outboard' shaft. A clutch spring may control the resistance to rotation of the inboard shaft within the outboard shaft. During opening and closing, the display may rotate about one of the pivot pins prior to rotating about the other.

### Summary of the Invention

The present invention relates to a friction clutch according to claim 7 and to a corresponding electronic assembly enclosure according to claim 1.

Briefly described, the present invention concerns a friction clutch for use with a dual pivot point hinge. The clutch comprises a support structure having two parallel end flanges, each end flange has a pair of apertures for accepting first and second clutch axles. The parallel end flanges are connected by a center beam disposed between the pair of apertures. The center beam employs spring anchors which establish spring member position and prevent spring member rotation. Each spring member has a loop that determines a spring wrap direction.

During assembly, the first clutch axle is inserted into the first aperture of the first end flange, through the loop of the first spring member and through the first aperture of the second end flange. Likewise, the second clutch axle is inserted into the second aperture of the first end flange, through the loop of the second spring member and through the second aperture of the second end flange.

In response to torque exerted upon the clutch axles during hinge operation, the first and second spring members exert a braking friction upon the first and second clutch axles, said braking friction permits the rotation of but one clutch axle at a time. Such restricted rotation assures proper 180 degree operation of each hinge member associated with the 360 degree hinge, thereby eliminating the alignment problems typically experienced by dual pivot point hinges.

### Brief Description of the Drawings

FIG. 1 is a top, right, and front perspective view showing an embodiment of a portable computer enclosure which employs the present invention;
FIG. 2 is a left side elevation view of the portable computer enclosure of FIG. 1 wherein the display portion is opened approximately 180 degrees relative to the body portion and about the first pivot point axis;
FIG. 3 is a left side elevation view of the portable computer enclosure of FIG. 1 wherein the display portion is opened approximately 180 degrees relative to the body portion and about the second pivot point axis;
FIG. 4 is an exploded view of the portable computer enclosure of FIG. 2; and
FIG. 5 is a partial cross-sectional view, taken along lines 5-5 in FIG. 4 and looking in the direction of the arrows, of the friction clutch as illustrated in FIG. 4.

### Detailed Description of a Preferred Embodiment

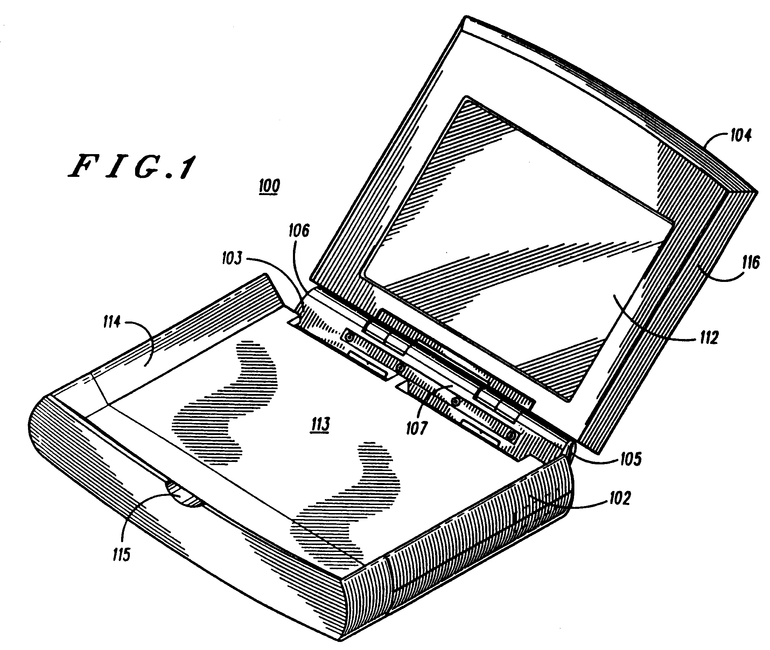

The present invention is a friction clutch for use with a dual pivot point (polycentric) hinge like those employed in the field of portable computer housing assemblies and/or enclosures. FIG. 1 is a top, right, and front perspective view showing an embodiment of a portable computer enclosure which employs the present invention. The portable computer enclosure, shown generally by reference numeral 100, comprises a body portion 102 and a cover 104 which are coupled together by a hinge 106.

The cover 104 comprises a display screen 112, which is preferably a touch-sensitive screen employing well known touch screen techniques by which data may be entered into the computer housed within the enclosure 100. Data entry may be by way of a finger or stylus as is known in the art.

Body portion 102 comprises a central cavity 113 which is adapted to receive the display screen 112 when cover 104 is in a closed orientation. At least three interior side walls 114 of cavity 113 are tapered from the base of the cavity upwards and outwards. The edges 116 of cover 104 are tapered to mate with the side walls 114 of cavity 113 when cover 104 is in the fully closed position. A locking mechanism 115 is provided in an upper surface of body portion 102 and a lower surface of cover 104 to enable the user to lock cover 104 in place when fully closed, thereby protecting the display screen 112 during storage and/or transportation.

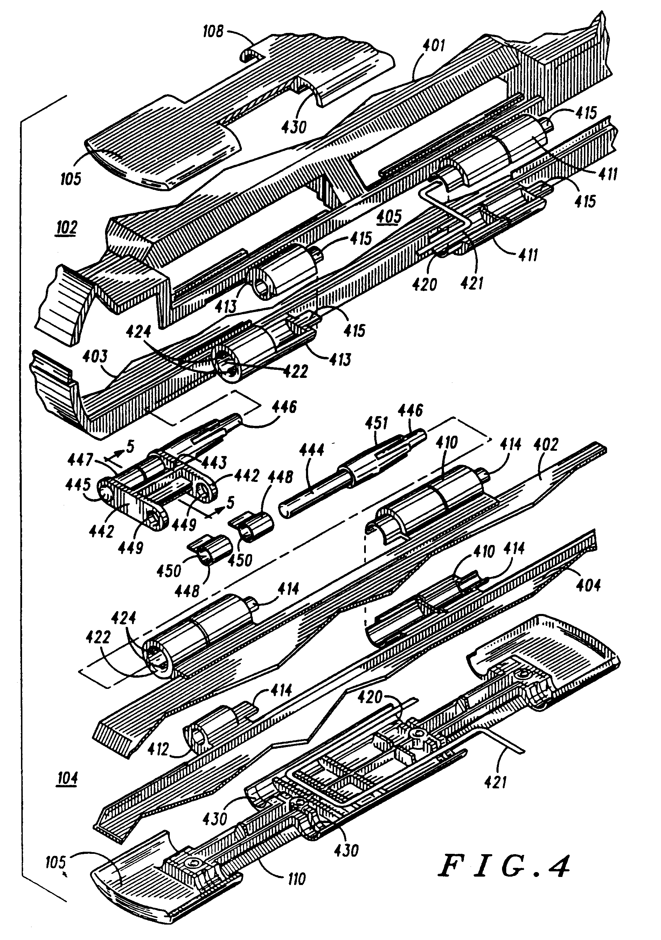

Hinge 106 comprises first and second hinge members 108 and 110 as shown with reference to FIG 4. Each hinge member 108 and 110 comprises a central portion 107 and two end portions 103 and 105, respectively. The central portion 107 is designed to mate with two parallel axles (not shown), one of which is associated primarily with body portion 102 and the other of which is associated primarily with cover 104. When central portions 107 of hinge members 108 and 110 are assembled around the two parallel axles and connected together with end caps 103 and 105 which snap together, body portion 102 and cover 104 are connected together via a 360 degree dual pivot point hinge 106.

Of note, flexible circuitry and/or wiring connections are employed within channels disposed within the parallel axles and the hinge members to allow the necessary electrical connections between body portion 102 and cover 104 while permitting full 360 degrees of motion between cover 104 and body portion 102. Because such circuitry and/or wiring is disposed within hollow channels within hinge axles (not shown) and hinge members 108 and 110, they are protected from the possibility of external damage, as well as any damage due to the stress typically associated with continuous flexing of thin conductors.

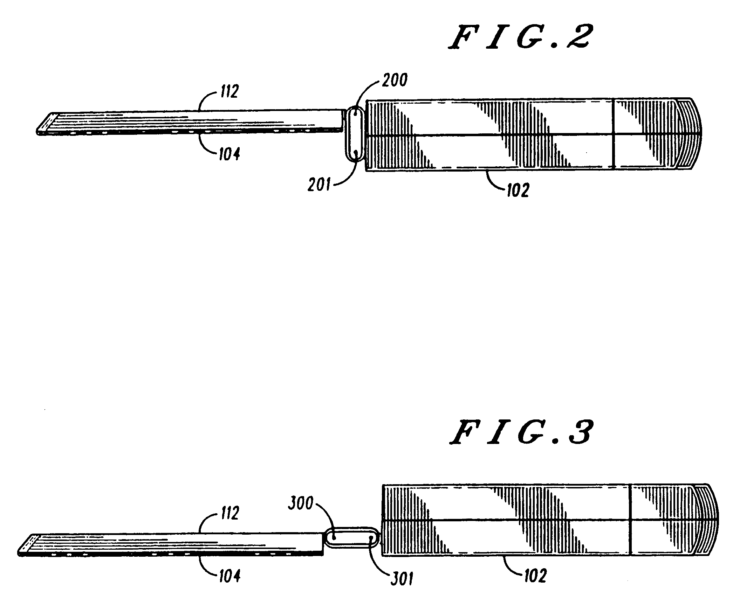

FIGS. 2 and 3 are both left side elevation views of the portable computer enclosure of FIG. 1. FIG. 2 shows one basic display screen orientation, namely a "lap-top mode" wherein cover 104 and display screen 112 are angled at approximately 180 degrees relative to body portion 102 about a first pivot point axis 200. FIG. 3 shows yet another basic display screen orientation wherein cover 104 and display screen 112 are opened approximately 180 degrees relative to body portion 102 about a second pivot point axis 301.

As cover 104 is moved from the position shown in FIG. 3 to its fully closed position it will be appreciated that cover 104 may freely pivot about either axis 300 or 301 of hinge 106. This unrestricted freedom of motion presents a number of potential problems. For example, because of the unrestricted freedom of motion, hinge 106 is prone to slip out of the position it assumes when functioning as a 180 degree hinge about pivot point (axis) 300. The propensity of hinge 106 to freely rotate about either pivot point 300 or 301 creates the possibility that cover 104 will misalign with body portion 102 and become ajar when it reaches the fully closed position. Such misalignment may cause latching mechanism 115 to fail to properly latch. The failure of cover 104 to properly latch, if undetected, could result in the inadvertent opening of cover 104 during transportation. Such an unplanned opening of the cover could result in catastrophic damage to display screen 112.

In order to alleviate this potential problem, hinge 106 employs a friction clutch as described herein below. This device operates to prevent cover 104 from slipping, relative to body portion 102, after cover 104 has been set in a desired orientation by the user. Moreover, this friction clutch operates to permit cover 104 to move relative to said body portion 102 about but one pivot axis at a time. By restricting the cover's movement relative to body portion 102 to but a single pivot point at a time, the clutch assure proper 180 degree operation of each hinge member associated with hinge 106, thereby eliminating the misalignment problems typically experienced by dual pivot point (polycentric) hinges of the type described in association with the preferred embodiment of the present invention.

FIG. 4 is a partial exploded view of the portable computer enclosure 100 as shown in FIG. 1. Commencing with body 102 of enclosure 100, FIG. 4 depicts a partial view of the body 102 which comprises an upper and a lower portion 401 and 403, which respectively combine to define a cavity 405 which maintains the electronic circuitry comprising a computer or other electronic device for enclosure within body portion 102 as determined by a particular application.

Fashioned into external side walls of upper and lower portions 401 and 403 of body 102 are hollow axle members 411 and 413. When upper and lower sections 401 and 403 of body portion 102 are assembled, hollow axle members 411 and 413 join together to define a pair of hollow parallel axles which are thereafter associated with body portion 102. As shown in FIG. 4, male features 415 of hollow axle members 411 and 413 engage female features 430 of hinge members 108 and 110 during assembly.

Referring now to cover 104, FIG. 4 depicts a partial view of cover 104 which, like body portion 102, is comprised of upper and lower sections 402 and 404, which respectively combine to define a cavity 406 which maintains the display screen 112 and/or other electronic circuitry for enclosure within cover 104. Fashioned into external side walls of upper and lower sections 402 and 404 are hollow axle members 410 and 412. When upper and lower sections 402 and 404 of cover 104 are assembled, hollow axle members 410 and 412 join together to define a pair of hollow parallel axles which are thereafter associated with cover 104. As shown in FIG. 4, male features 414 of hollow axle members 410 and 412 engage female features 430 of hinge members 108 and 110 during assembly to complete the 360 degree hinge 106 and couple body portion 102 to cover 104.

With reference to FIG. 4 the hollow axle members 411 of body 102, hollow axle members 410 of cover 104, and hinge members 108 and 110 are fashioned to form a channel 420 for accepting flexible circuitry and/or wiring connections 421 which facilitate an electrical connection between the electronic circuitry disposed within cavity 405 of body portion 102 and display screen 112 disposed within the cavity 406 of cover 104. As previously mentioned, the channel 420 protects the wiring 421 from external damage and limits the stress typically associated with the continuous flexing of the thin metal conductors. Similarly, hollow axle members 413 of body portion 102 and hollow axle members 412 of cover 104 are fashioned to form chambers 422 having tongues 424 for use as described herein below.

In accordance with the preferred embodiment, body portion 102, hollow axle members 411 and 413, hinge members 108 and 110, cover 104, and hollow axle members 410 and 412 are made of a plastic such as polycarbonate. This material combines a relatively high impact performance with enough tensile strength in order to insure mechanical and environmental stability. In addition, polycarbonate components are easily fixed together utilizing well known adhering, fusing and welding techniques. Notwithstanding, several other plastics provide available alternatives, such as, but not limited to: Polyaryl Sulfone and Liquid Crystal Polymers.

It will be appreciated by those skilled in the art that both body portion 102, hollow axle members 411 and 413, hinge members 108 and 110, cover 104, and hollow axle members 410 and 412 of the present invention are producible utilizing various injection-molding and extrusion techniques. For additional discussion on state of the art injection molding and extrusion techniques, refer to: Dubois, H. J., Pribble, W. I., "Plastics Mold Engineering Handbook," 3rd Edition, Van Nostrund Reinhold Company, New York 1978.

It will be further appreciated by those skilled in the art, that the body portion 102, hollow axle members 411 and 413, hinge members 108 and 110, cover 104, and hollow axle members 410 and 412 of the present invention may be made of metal and formed via any of the well known die casting techniques, without departing from the spirit of the present invention.

Continuing with the description of FIG. 4, an exploded view of a friction clutch 440 for use by the dual pivot point hinge of the present invention is shown. Friction clutch 440 comprises frame 441 having end flanges 442 and center beam 443, clutch axles 444 and 445, torque sleeves 446 and wrap spring members 447 and 448. As shown, each end flange 442 has two apertures 449 for accepting torque axles 444 and 445, respectively. Each clutch axle 444 and 445 is equipped with a torque sleeve 446. The ends of clutch axles 444 and 445 bearing sleeves 446 are inserted into chambers 422 constructed by hollow axle members 412 and 413 of cover 104 and body portion 102, respectively. Torque sleeves 446 operate to secure the upper and lower sections 401 and 403 of body portion 102 and upper and lower sections 402 and 404 of cover 104 together during assembly.

As previously mentioned, each chamber 422 is fashioned to comprise tongues 424. In correspondence therewith, sleeves 446 are fashioned to comprise grooves 451 which mate with tongues 424 disposed within chambers 422. As will be appreciated, the tongue 424 and groove 451 combination operates to transfer torque from hinge axles 412 and 413 to clutch axles 444 and 445, respectively.

As shown, the unsleeved end of clutch axle 444 or 445 is passed through an aperture 449 in an end flange 442, through a loop 450 in wrap spring members 447 or 448 and then through an aperture 449 in a second end flange 442. The entire friction clutch assembly 440 is disposed within an end cap portion 103 or 105 of hinge 106 of FIG. 1.

During operation of 360 degree hinge 106, friction clutch 440 operates to keep cover 104 from slipping, relative to body 102, after cover 104 has been set in a desired orientation by the device user. In addition, friction clutch 440 operates to permit cover 104 to move relative to said body portion 102 about one pivot axis (444 or 445) at a time. By restricting cover 104 movement relative to body 102 to a single pivot point at a time, clutch 440 assures proper 180 degree operation of each hinge member associated with the 360 degree hinge of the present invention. Single pivot point operation, in accordance with the present invention, tends to eliminate those alignment problems typically experienced by dual pivot point (polycentric) hinges.

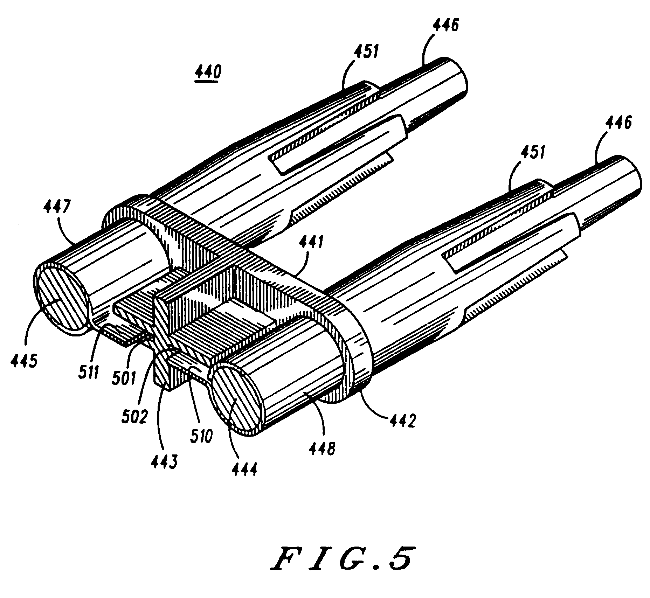

FIG. 5 is a partial cross-sectional view, taken along lines 5-5 in FIG. 4 and looking in the direction of the arrows, of friction clutch 440. As shown, clutch frame 441 comprises end flange 442 and center beam 443. Center beam 443 employs a first and a second spring notch 501 and 502 which run parallel to the axes of apertures 449 and parallel to the axes of clutch axles 444 and 445.

Clutch axles 444 and 445 are shown projecting through apertures 449 in the end flange 442. Wrap spring 448 and 447 wrap around and engage respective clutch axles 444 and 445 as shown. Wrap Springs 447 and 448 are anchored via tabs 511 and 510 which are inserted into the first and second spring notches 501 and 502, respectively. Spring notches 501 and 502 act as anchors which establish wrap spring positioning and prevent wrap spring rotation during the rotation of clutch axles 444 and 445.

Wrap springs 448 and 447 are designed to provide differing amounts of braking friction (i.e., resistance) to clutch axles 444 and 445 depending upon the direction of the clutch axle's rotation. In particular, the magnitude of the wrap spring braking friction exerted upon a clutch is greatest when the clutch axle's direction of rotation coincides with the wrap direction of an associated wrap spring. Conversely, the magnitude of the wrap spring braking friction exerted upon a clutch axle is least when the clutch axle's direction of rotation is opposite to the wrap direction of an associated wrap spring.

In accordance with the present invention, maximum wrap spring braking resistance should not prohibit clutch axle rotation, but should provide greater resistance to rotation than that exerted during rotation in a direction opposite to the wrap of the associated wrap spring. Of note, when a clutch axle ceases to rotate, the associated wrap spring will engage the axle via loop 450 of FIG. 4 to hold the axle's position relatively constant in order to avoid slippage of cover 104.

An advantage of the present invention is that differing amounts of braking friction are exerted upon clutch axles 444 and 445 by wrap springs 448 and 447 in order to permit cover 104 to move relative to body 102 about but a single pivot point axis at a time, thereby assuring proper 180 degree operation of each hinge member of dual pivot point hinge 106 and eliminating the misalignment problems exhibited by prior dual pivot point hinges.

With reference to FIG. 5, friction clutch 440 operates to isolate movement of cover 104 relative to body portion 102 about a single pivot point at a time. Isolated pivot point movement is achieved in both the opening and closing direction by selectively orienting the directionality of wrap springs 447 and 448 as shown in FIG. 5. Specifically, wrap spring 448, which is associated with torque axle 444, which in turn is coupled to cover 104, is oriented such that the wrap direction as viewed in FIG. 5 is counterclockwise. Wrap spring 447, which is associated with torque axle 445, which is in turn coupled to body 102, is oriented such that the wrap direction as viewed in FIG. 5 is counter clockwise.

During the opening of cover 104, torque is applied to clutch axle 444 which attempts to rotate axle 444 in a clockwise direction (i.e., opposite to the direction of the wrap of wrap spring 448). In this situation, wrap spring 448 will exert a minimum (least) amount of braking friction upon clutch axle 444. The opening of cover 104 also causes torque to be applied to clutch axle 445. This torque attempts to rotate clutch axle 445 in a counterclockwise direction (i.e. in the direction of the wrap of wrap spring 447). In this situation, wrap spring 447 will exert a maximum amount of braking friction upon clutch axle 445. In the above-described scenario, cover 104 will tend to rotate 180 degrees relative to body portion 102 and about clutch axle 444 until it reaches a mechanical stop (not shown). Once cover 104 reaches the stop position, e.g., 180 degrees relative to body portion 102, the remaining 180 degrees of travel relative to body portion 102 will be about clutch axle 445.

During the closing of cover 104, torque is applied to clutch axle 444 which attempts to rotate clutch axle 444 in the direction of the wrap of wrap spring 448. In this situation, wrap spring 448 will exert a maximum amount of braking friction upon clutch axle 444. The closing of cover 104 will likewise exert torque upon clutch axle 445 which attempts to rotate clutch axle 445 in a direction opposite to the direction of the wrap of wrap spring 447. Under these circumstances, cover 104 will tend to rotate 180 degrees relative to body portion 102 and about clutch axle 445 until it reaches a mechanical stop (not shown). From this point on, cover 104 will rotate 180 degrees relative to body portion 102 about clutch axle 444 back to the fully closed position.

It will be appreciated by those skilled in the art that various wrap spring orientations may be employed by clutch 440 in order to achieved the controlled operation of hinge 106 or the controlled opening and closing of cover 104, depending upon the particular application. Such modified orientations are considered well within the scope of the present invention according to the following claims.

## Claims

1. An electronic assembly enclosure comprising:
a body (102);
a cover (104);
hinging means (106) for hinging said cover to said body such that said cover is movable relative to said body and locatable in a plurality of positions over substantially the whole range from 0 to 360 degrees relative to said body, said hinging means including first and second hinge axles (430) for permitting said cover to move relative to said body about a first and a second pivot axis; and a friction clutch (440), having first and second clutch axles (444, 445) coupled to the first and second hinge axles for receiving torque from the first and second hinge axles during rotation of the cover relative to the body, said friction clutch further comprising first and second spring members (447, 448) wrapped around and in frictional contact with the first and second clutch axles for exerting a braking friction upon the first and second clutch axles in response to the torque exerted upon the clutch axles, said braking friction varying according to the direction of relative rotation between each clutch axle and its spring member so as to permit said cover to move relative to said body about but one pivot axis at a time.

2. The electronic assembly enclosure of claim 1 wherein the friction clutch further comprises an H-shaped support structure having two parallel end flanges (442), each end flange having a pair of apertures (449) for accepting a second end of the first and the second clutch axles, the parallel end flanges being connected by a center beam (443) disposed between the pair of apertures, the center beam having spring anchoring means (501,502).

3. The electronic assembly enclosure of claim 1 further comprising detachable hinge members, each member having end caps and a center section for coupling the first and second parallel and hollow hinge axle members of the body to the first and second parallel and hollow hinge axle members of the cover to form a 360 degree dual pivot point hinge having first and second pivot point axes defined by the parallel and hollow hinge axle members of the body and the cover, for permitting the cover to rotate relative to the body about the first and the second pivot point axes through a plurality of positions from 0 to 360 degrees relative to the body.

4. The electronic assembly enclosure of claim 3 wherein the first hollow hinge axle member of the cover and the first hollow hinge axle member of the body are fashioned to define a hollow channel for accepting electrical conductors which provide an electrical connection between the body and the cover.

5. The electronic assembly enclosure of claim 3 wherein the second hollow hinge axle member of the cover and the second hollow hinge axle member of the body are fashioned to comprise means for transferring torque to the friction clutch in response to movement of the cover relative to the body.

6. The electronic assembly enclosure of claim 1 wherein the hinging means comprises a first hollow hinge axle member and a second hollow hinge axle member fashioned to define a hollow channel for accepting electrical conductors which provide an electrical connection between the body and the cover at a first end of the hinging means.

7. A friction clutch having first (444) and second (445) clutch axles for use with a dual pivot point hinge, said hinge having first and second hinge axles for transferring torque to said first and second clutch axles, said friction clutch comprising:
a support structure (441) having first and second parallel end flanges (442), each end flange having a pair of apertures (449) for accepting an end of said first and said second clutch axles (444, 445), respectively, said first and second parallel end flanges (442) being connected by a center beam (443) disposed between said pair of apertures, said center beam (443) having spring anchoring means (501, 502); and
first and second spring members (447, 448), anchored to the support structure (441) via the spring anchoring means (501, 502), each spring member having a loop that determines a spring wrap direction,
wherein said end of said first clutch axle (444) is inserted into the first aperture of the first end flange (442), through the loop of said first spring member and through the first aperture of the second end flange, and said end of said second clutch axle (445) is inserted into the second aperture of the first end flange, through the loop of said second spring member and through the second aperture of the second end flange such that the first and second spring members exert a braking friction upon the first and second clutch axles, in response to torque exerted upon the axles by the hinge members, said braking friction varying according to the direction of relative rotation between each clutch axle and its spring member so as to permit rotation about but one clutch axle at a time.

8. The friction clutch of claim 7 wherein the magnitude of the braking friction exerted upon a clutch axle by a spring member changes as a function of the direction of the axle's rotation.

9. The friction clutch of claim 8 wherein the magnitude of the braking friction exerted upon a clutch axle by a spring member is greatest when the direction of the axle's rotation coincides with the spring wrap direction.

10. The friction clutch of claim 8 wherein the magnitude of the braking friction exerted upon a clutch axle by a spring member is least when the direction of the axle's rotation is opposite to the spring wrap direction.

11. The friction clutch of claim 7 wherein the first and second spring members are selected from the group of springs consisting of: wrap springs and coiled springs.

## Patentansprüche

1. Gehäuse für eine elektronische Anordnung mit:
einem Körper (102);
einer Abdeckung (104);
einer Gelenkeinrichtung (106) zum Anlenken der Abdeckung an den Körper, so daß die Abdeckung relativ zum Körper beweglich ist und in einer Mehrzahl von Positionen über im wesentlichen den vollständigen Bereich von 0 bis 360 Grad relativ zum Körper lokalisierbar ist, wobei die Gelenkeinrichtung eine erste und zweite Gelenkachse (430) zum Ermöglichen, daß sich die Abdeckung relativ zum Körper um eine erste und zweite Scharnierachse bewegt, aufweist; und
einer Reibungskupplung (440) mit einer ersten und zweiten Kupplungsachse (444, 445), welche mit der ersten und zweiten Gelenkachse verbunden sind, zum Aufnehmen des Drehmoments von der ersten und zweiten Gelenkachse während der Rotation der Abdeckung relativ zum Körper, wobei die Reibungskupplung weiterhin ein erstes und zweites Federelement (447, 448) aufweist, welche um und in Reibungskontakt mit der ersten und zweiten Kupplungsachse gewickelt sind, zum Ausüben einer Bremsreibung auf die erste und zweite Kupplungsachse ansprechend auf das Drehmoment, welches auf die Kupplungsachsen ausübbar ist, wobei die Bremsreibung entsprechend der Richtung der relativen Rotation zwischen einer jeweiligen Kupplungsachse und ihrem Federelement variiert, um zu ermöglichen, daß sich die Abdeckung relativ zum Körper um nur eine Scharnierachse zu einer Zeit bewegt.

2. Gehäuse für eine elektronische Anordnung nach Anspruch 1, dadurch gekennzeichnet, daß die Reibungskupplung weiterhin eine H-förmige Halterungsstruktur mit zwei parallelen Endflanschen (442) aufweist, wobei jeder Endflansch ein Paar von Öffnungen (449) zum Aufnehmen eines zweiten Endes der ersten und der zweiten Kupplungsachse aufweist, wobei die parallelen Endflansche durch einen zentralen Balken (443) verbunden sind, der zwischen dem Paar von Öffnungen angeordnet ist, und wobei der zentrale Balken eine Federverankerungseinrichtung (501, 502) aufweist.

3. Gehäuse für eine elektronische Anordnung nach Anspruch 1, gekennzeichnet durch abnehmbare Gelenkelemente, wobei jedes Element Endkappen und einen zentralen Abschnitt zum Verbinden des ersten und zweiten parallelen und hohlen Gelenkachsenelements des Körpers mit dem ersten und zweiten parallelen und hohlen Gelenkachsenelement der Abdeckung aufweist, um ein 360-Grad-Doppelscharniergelenk mit einer ersten und zweiten Scharnierachse zu bilden, welche definiert sind durch die parallelen und hohlen Gelenkachsenelemente des Körpers und der Abdeckung, um zu ermöglichen, daß die Abdeckung relativ zum Körper um die erste und zweite Scharnierachse über eine Vielzahl von Positionen von 0 bis 360 Grad relativ zum Körper rotieren kann.

4. Gehäuse für eine elektronische Anordnung nach Anspruch 3, dadurch gekennzeichnet, daß das erste hohle Gelenkachsenelement der Abdeckung und das erste hohle Gelenkachsenelement des Körpers derart gestaltet sind, daß sie einen hohlen Kanal zum Aufnehmen elektrischer Leiter vorsehen, welche eine elektrische Verbindung zwischen dem Körper und der Abdeckung bilden.

5. Gehäuse für eine elektronische Anordnung nach Anspruch 3, dadurch gekennzeichnet, daß das zweite hohle Gelenkachsenelement der Abdeckung und das zweite hohle Gelenkachsenelement des Körpers derart gestaltet sind, daß sie eine Einrichtung zum Übertragen des Drehmoments auf die Reibungskupplung ansprechend auf die Bewegung der Abdeckung relativ zum Körper umfassen.

6. Gehäuse für eine elektronische Anordnung nach Anspruch 1, dadurch gekennzeichnet, daß die Gelenkeinrichtung ein erstes hohles Gelenkachsenelement und ein zweites hohles Gelenkachsenelement aufweist, welche derart gestaltet sind, daß sie einen hohlen Kanal zum Aufnehmen elektrischer Leiter vorsehen, welche eine elektrische Verbindung zwischen dem Körper und der Abdeckung an einem ersten Ende der Gelenkeinrichtung bilden.

7. Reibungskupplung mit einer ersten (444) und einer zweiten (445) Kupplungsachse zur Verwendung mit einem Doppelscharniergelenk, wobei das Gelenk eine erste und zweite Gelenkachse zum Übertragen eines Drehmoments an die erste und zweite Kupplungsachse aufweist, wobei die Reibungskupplung aufweist:
eine Halterungsstruktur (441) mit einem ersten und zweiten parallelen Endflansch (442), wobei jeder Endflansch ein Paar von Öffnungen (449) zum Aufnehmen eines Endes der ersten und zweiten Kupplungsachse (444, 445) aufweist, wobei der erste und zweite parallele Endflansch (442) durch einen zentralen Balken (443) verbunden sind, der zwischen dem Paar von Öffnungen angeordnet ist, wobei der zentrale Balken (443) eine Federverankerungseinrichtung (501, 502) aufweist; und
ein erstes und zweites Federelement (447, 448), welche an der Halterungsstruktur (441) über die Federverankerungseinrichtung (501, 502) verankert sind, wobei jedes Federelement eine Schleife aufweist, welche eine Federwickelrichtung bestimmt,
wobei das Ende der ersten Kupplungsachse (444) in die erste Öffnung des ersten Endflansches (442) durch die Schleife des ersten Federelements und durch die erste Öffnung des zweiten Endflansches eingesetzt ist und das Ende der zweiten Kupplungsachse (445) in die zweite Öffnung des ersten Endflansches durch die Schleife des zweiten Federelements und durch die zweite Öffnung des zweiten Endflansches eingesetzt ist, so daß das erste und zweite Federelement eine Bremsreibung auf die erste und zweite Kupplungsachse ansprechend auf ein Drehmoment ausüben, das auf die Achsen durch die Gelenkelemente ausgeübt wird, wobei die Bremsreibung gemäß der Richtung der relativen Rotation zwischen einer jeweiligen Kupplungsachse und ihrem Federelement variiert, um eine Rotation um nur eine Kupplungsachse zu einer Zeit zu ermöglichen.

8. Reibungskupplung nach Anspruch 7, dadurch gekennzeichnet, daß die Größe der Bremsreibung, welche auf eine Kupplungsachse durch ein Federelement ausübbar ist, sich als eine Funktion der Richtung der Rotation der Achse ändert.

9. Reibungskupplung nach Anspruch 8, dadurch gekennzeichnet, daß die Größe der Bremsreibung, welche durch ein Federelement auf eine Kupplungsachse ausübbar ist, am größten ist, wenn die Richtung der Rotation der Achse zusammenfällt mit der Federwickelrichtung.

10. Reibungskupplung nach Anspruch 8, dadurch gekennzeichnet, daß die Größe der Bremskraft, welche auf eine Kupplungsachse durch ein Federelement ausübbar ist, am geringsten ist, wenn die Richtung der Rotation der Achse entgegengesetzt zur Federwicklungsrichtung ist.

11. Reibungskupplung nach Anspruch 7, dadurch gekennzeichnet, daß das erste und zweite Federelement ausgewählt sind aus der Gruppe von Federn, welche besteht aus: Wickelfedern und Spiralfedern.

## Revendications

1. Enceinte d'ensemble électronique comprenant :
un corps (102) ;
un volet (104) ;
un moyen formant charnière (106) permettant de Constituer une charnière entre ledit corps et ledit volet qui est mobile par rapport audit corps et pouvant être situé en une pluralité de positions sensiblement entre 0 et 360 degrés par rapport audit corps, ledit moyen formant charnière comportant des premier et deuxième axes de charnière (430) permettant audit volet de se déplacer par rapport audit corps autour d'un premier et d'un deuxièmes axes de pivot ; et un accouplement à friction (440), ayant des premier et deuxième axes d'accouplement (444, 445) couplés aux premier et deuxième axes de charnière pour recevoir un couple provenant des premier et deuxième axes de charnière pendant la rotation du volet par rapport au corps, ledit accouplement à friction comprenant en outre des premier et deuxième éléments de ressort (447, 448) enroulés autour des et en contact par frottement avec les premier et deuxième axes d'accouplement pour exercer un frottement de freinage sur les premier et deuxième axes d'accouplement, en réponse au couple exercé sur les axes d'accouplement, ledit frottement de freinage variant en fonction du sens de rotation relative entre chaque axe d'accouplement et son élément de ressort de façon à permettre audit volet de se déplacer par rapport audit corps autour d'un axe de pivot à la fois.

2. Enceinte d'ensemble électronique selon la revendication 1, dans laquelle l'accouplement à friction comprend en outre une structure de support en forme de H ayant deux brides d'extrémité parallèles (442), chaque bride d'extrémité ayant une paire d'ouvertures (449) permettant d'accepter une deuxième extrémité des premier et deuxième axes d'accouplement, les brides d'extrémité parallèles étant reliées par un ergot central (443) disposé entre la paire d'ouvertures, l'ergot central ayant des moyens d'ancrage de ressort (501, 502).

3. Enceinte d'ensemble électronique selon la revendication 1, comprenant en outre des éléments de charnière amovible, chaque élément ayant des capuchons d'extrémité et une section centrale pour coupler les premier et deuxième éléments d'axe de charnière creux et parallèles du corps aux premier et deuxième éléments d'axe de charnière creux et parallèles du volet de façon à former une charnière à double pivot de 360° ayant des premier et deuxième axes de pivot définis par les éléments d'axe de charnière creux et parallèles du corps et du volet, permettant au volet de tourner par rapport au corps autour des premier et deuxième axes de pivot par le biais d'une pluralité de positions entre 0 et 360° par rapport au corps.

4. Enceinte d'ensemble électronique selon la revendication 3, dans laquelle le premier élément d'axe de charnière creux du volet et le premier élément d'axe de charnière creux du corps sont façonnés de façon à définir une rainure creuse permettant d'accepter des conducteurs électriques qui assurent une connexion électrique entre le corps et le volet.

5. Enceinte d'ensemble électronique selon la revendication 3, dans laquelle le deuxième élément d'axe de charnière creux du volet et le deuxième élément d'axe de charnière creux du corps sont façonnés de façon à comprendre des moyens permettant de transférer le couple à l'accouplement à friction en réponse au mouvement du volet par rapport au corps.

6. Enceinte d'ensemble électronique selon la revendication 1, dans laquelle le moyen formant charnière comprend un premier élément d'axe de charnière creux et un deuxième élément d'axe de charnière creux façonné de façon à définir une rainure creuse permettant d'accepter des conducteurs électriques qui assurent une connexion électrique entre le corps et le volet à une première extrémité du moyen formant charnière.

7. Accouplement à friction ayant des premier (444) et deuxième (445) axes d'accouplement pouvant être utilisés avec une charnière à double pivot, ladite charnière ayant des premier et deuxième axes de charnière pour transférer un couple auxdits premier et deuxième axes d'accouplement, ledit accouplement à friction comprenant :
une structure de support (441) ayant des première et deuxième brides d'extrémité parallèles (442), chaque bride d'extrémité ayant une paire d'ouvertures (449) permettant d'accepter une extrémité desdits premier et deuxième axes d'accouplement (444, 445), respectivement, lesdites première et deuxième brides d'extrémité parallèles (442) étant reliées par un ergot central (443) ayant des moyens d'ancrage de ressort (501, 502) ; et
des premier et deuxième éléments de ressort (447, 448) ancrés à la structure de support (441) par l'intermédiaire des moyens d'ancrage de ressort (501, 502), chaque élément de ressort ayant une boucle qui détermine un sens d'enroulement du ressort,
dans lequel ladite extrémité dudit premier axe d'accouplement (444) est insérée dans la première ouverture de la première bride d'extrémité (442) par le biais de la boucle dudit premier élément de ressort et par le biais de la première ouverture de la deuxième bride d'extrémité, et ladite extrémité dudit deuxième axe d'accouplement (445) est insérée dans la deuxième ouverture de la première bride d'extrémité, par le biais de la boucle dudit deuxième élément de ressort et par le biais de la deuxième ouverture de la deuxième bride d'extrémité de telle sorte que les premier et deuxième éléments de ressort exercent un frottement de freinage sur les premier et deuxième axes d'accouplement, en réponse au couple exercé sur les axes par les éléments de charnière, ledit frottement de freinage variant en fonction du sens de rotation relative entre chaque axe d'accouplement et son élément de ressort de façon à permettre une rotation autour d'un axe d'accouplement à la fois.

8. Accouplement à friction selon la revendication 7, dans lequel l'amplitude du frottement de freinage exercé sur un axe d'accouplement par un élément de ressort change en fonction du sens de rotation de l'axe.

9. Accouplement à friction selon la revendication 8, dans lequel l'amplitude du frottement de freinage exercé sur un axe d'accouplement par un élément de ressort est la plus importante lorsque le sens de rotation de l'axe coïncide avec le sens d'enroulement du ressort.

10. Accouplement à friction selon la revendication 8, dans lequel l'amplitude du frottement de freinage exercé sur un axe d'accouplement par un élément de ressort est la moins importante lorsque le sens de rotation de l'axe est opposé au sens d'enroulement du ressort.

11. Accouplement à friction selon la revendication 7, dans lequel les premier et deuxième éléments de ressort sont choisis dans le groupe de ressorts comprenant : des ressorts enroulés et des ressorts à boudin.
